# EUROPÄISCHE PATENTANMELDUNG

(11) **EP 1 489 656 A2**
(43) Veröffentlichungstag der Anmeldung: **22.12.2004**
(21) Anmeldenummer: 04101941.5
(22) Anmeldetag: 05.05.2004
(51) Int. Cl.: H01L 23/00, H01L 23/544

(54) **Verfahren zur Herstellung eines bruchfesten scheibenförmigen Gegenstands sowie zugehörige Halbleiterschaltungsanordnung**

(30) Priorität: 12.06.2003 DE 10326507
(71) Anmelder: Infineon Technologies AG, 81669 München (DE)
(72) Erfinder: Kröner, Friedrich, 9500, Villach (AT)
(74) Vertreter: Karl, Frank

(57) **Zusammenfassung**

Die vorliegende Erfindung betrifft ein Verfahren zur Herstellung eines bruchfesten scheibenförmigen Gegenstands sowie einer zugehörigen Halbleiterschaltungsanordnung, wobei ein Graben (G1, G2) im Bereich eines Sägerahmens (4) eines Substrats (1A) ausgebildet und mit einem schubspannungsfesten Material (SF) aufgefüllt wird. An der Vorderseite des Substrats (1A) wird ferner eine Galvanisierungsmaske (5) mit frei liegenden Bereichen ausgebildet, wobei durch eine Galvanisierung die frei liegenden Bereiche mit einer galvanischen Füllschicht (11) aufgefüllt werden. Auf diese Weise lassen sich nicht nur auftretende Schubspannungen wesentlich verringern, sondern auch eine mechanische Stabilität verbessern, wodurch sich die Handhabbarkeit insbesondere von ultradünnen Halbleiterwafern wesentlich verbessert.

## Beschreibung

Die vorliegende Erfindung bezieht sich auf ein Verfahren zur Herstellung eines bruchfesten scheibenförmigen Gegenstands sowie einer zugehörigen Halbleiterschaltungsanordnung und insbesondere auf ein Verfahren zur "seed-layer"-freien galvanischen Herstellung eines ultradünnen bruchfesten Halbleiterwafers, wie er bei der Herstellung von integrierten Halbleiterschaltungen verwendet wird.

Für eine Vielzahl von gegenwärtigen und zukünftigen Anwendungen von elektronischen Bauelementen und insbesondere von integrierten Schaltungen (IC) ist es vorteilhaft, die Gesamtdicke dieser integrierten Schaltungen bzw. Halbleiterschaltungen auf wenige Mikrometer zu beschränken. Derart dünne Halbleiterschaltungen bzw. Chips haben eine sehr geringe Masse und eine sehr geringe Bauhöhe, weshalb sie für eine Vielzahl von Anwendungsfeldern beispielsweise in zukünftiger Wegwerf-Elektronik sowie für Chipkarten und Smartcards von Bedeutung sind.

Derartige ultradünne Halbleiterwafer können beispielsweise anhand von herkömmlichen Halbleiterwafern hergestellt werden, die eine Anfangsdicke von ca. 500 bis 1000 µm aufweisen und nach der Herstellung von jeweiligen Schaltelementen bzw. Halbleiterbauelementen bis auf eine entsprechende Enddicke dünngeschliffen werden.

Da jedoch für zukünftige Halbleiterbauelemente Dicken von deutlich weniger als 200 µm erwünscht sind, wobei ferner insbesondere eine beidseitige Strukturierung zur Ausbildung von beidseitig strukturierten Halbleiterbauelementen gefordert ist, besteht ein wesentliches Problem bei der Herstellung von ultradünnen Halbleiterschaltungen in der Vermeidung eines Bruches von Dünnwafern bzw. ultradünnen Halbleiterwafern.

Zum besseren Verständnis wird zunächst die Ursache der hohen Bruchgefahr von ultradünnen Halbleiterwafern im einzelnen beschrieben.

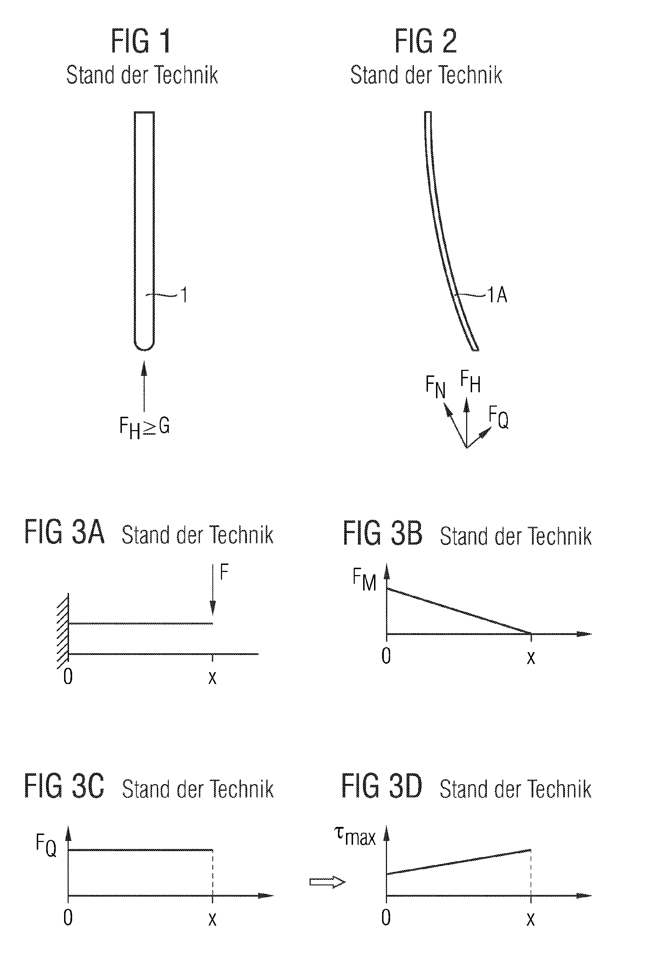

Figur 1 zeigt eine vereinfachte Seitenansicht eines scheibenförmigen Gegenstands wie z.B. eines Halbleiterwafers 1 mit einer Standarddicke von ca. 500 bis 1000 µm, wenn er beispielsweise in einer Horde abgestellt wird. Unter einer Horde versteht man üblicherweise ein Magazin für Halbleiterwafer, in dem bis zu 25 Stück stehend aufbewahrt werden können.

Beim Ablegen eines derartigen herkömmlichen Halbleiterwafers 1 erfährt dieser an einem Auflagepunkt eine sogenannte Auflagerreaktion F_{H}, die zumindest seinem Eigengewicht G entspricht. Diese Auflagerreaktion F_{H} bewirkt in erster Näherung Druckkräfte, die parallel zur Waferoberfläche wirken. Sogenannte Schubspannungen treten bei derartigen dicken Halbleiterwafern 1 üblicherweise nicht auf.

Demgegenüber zeigt Figur 2 eine vereinfachte Seitenansicht bei der Ablage eines Dünnwafers 1A in einer entsprechenden Horde bzw. einem Magazin für Halbleiterwafer. Da ein derartiger Dünnwafer auf Grund seiner dünnen Substratdicke kleiner 200 µm und eines asymmetrischen Schichtaufbaus grundsätzlich verbogen ist, spaltet sich gemäß Figur 2 die Auflagerreaktion F_{H} in eine sogenannte Normalkomponente F_{N} und eine Querkraftkomponente F_{Q} vektoriell auf. Wiederum ist die Auflagerreaktion F_{H} mindestens so groß wie das Gewicht G des Dünnwafers bzw. ultradünnen Halbleiterwafers 1A.

Zur Veranschaulichung der auf den und im Dünnwafer 1A wirkenden Kräfte sind in den Figuren 3A bis 3D die Schnittkräfte F_{M}, die Querkräfte F_{Q}, sowie die Schubspannungen τ in Abhängigkeit von einer Entfernung x für den vereinfachten Fall eines einseitig eingespannten Trägers dargestellt.

Figur 3A zeigt eine vereinfachte Darstellung eines derartigen bei x=0 eingespannten Trägers, wobei in einer Entfernung x eine Belastung F=F_{Q} wirkt. Gemäß Figur 3B sind demzufolge im Träger bzw. im Trägermaterial die Schnittkräfte F_{M} im Einspannpunkt Null maximal und im Belastungspunkt x minimal, wobei sie dazwischen linear verlaufen. Gemäß Figur 3C sind die Querkräfte F_{Q} in Abhängigkeit vom Ort dargestellt, wobei man für dieses Beispiel eine konstante Querkraft F_{Q} vom Einspannpunkt Null bis zum Belastungspunkt x erhält. Die Schnittkräfte F_{M} wirken hierbei als Drehmoment, welches jedoch keine Bruchgefahr darstellt, da es nur Zug- und Druckspannungen hervorruft, denen der Halbleiterwafer und insbesondere Silizium mühelos standhält.

Die in Figur 3C dargestellte Querkraft F_{Q} ruft jedoch im Material die in Figur 3D dargestellten Schubspannungen τ hervor, die in der Mitte eines nicht dargestellten Querschnitts ihren Maximalwert aufweisen. Wenn der in Figur 3A dargestellte Träger überall den selben Querschnitt aufweist, sind die Schubspannungen τ konstant für einen Einspannpunkt Null bis zu einem Belastungspunkt x. Dies gilt jedoch nicht für einen scheibenförmigen Gegenstand wie beispielsweise einen Halbleiterwafer.

Insbesondere bei Halbleiterwafern wird die äußere Belastung auch durch eine Beanspruchung bzw. den Stress einer Oxidschicht an einer Vorderseite eines Halbleiterwafers ersetzt. Demzufolge gibt es auch Spannungen τ, besonders nach der äußeren Krafteinwirkung durch eine Auflagerreaktion beispielsweise beim Ablegen eines Halbleiterwafers in einer Horde oder dem Ansaugen eines verbogenen Dünnwafers auf einem Vakuumchuck.

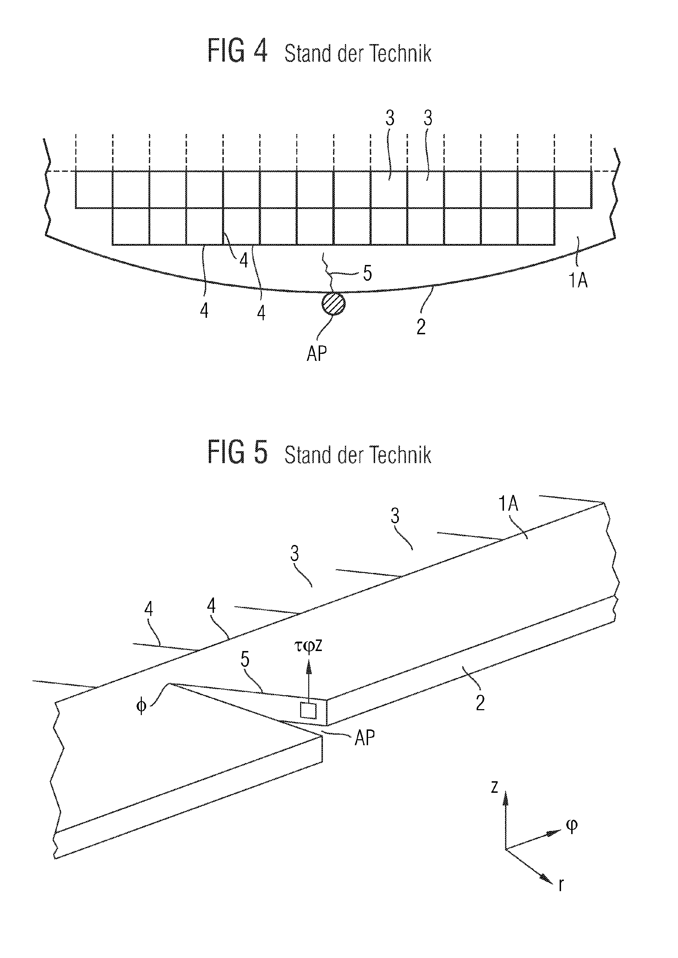

Figur 4 zeigt eine Teil-Draufsicht eines derartigen scheibenförmigen Gegenstandes, wie er beispielsweise als ultradünner Halbleiterwafer 1A bekannt ist.

Gemäß Figur 4 wird der ultradünne Halbleiterwafer 1A, der eine Vielzahl von integrierten Halbleiterschaltungen 3 bzw. Chips mit dazwischen liegenden Säge- bzw. Ritzrahmen 4 aufweist, über seinen Umfangsrand 2 auf einen Auflagepunkt AP beispielsweise in einer Horde abgelegt. Unter einem Säge- bzw. Ritzrahmen 4 wird nachfolgend der Abstand zwischen zwei Halbleiterschaltungen 3 verstanden, der üblicherweise zum Vereinzeln bzw. Sägen benötigt wird. An diesem Auflagepunkt AP werden demzufolge die vorstehend beschriebenen Auflagerreaktionen F_{H} erzeugt, woraus auch die unerwünschten Schubspannungen τ resultieren. Da jedoch insbesondere monokristallines Silizium, wie es üblicherweise für Halbleiterwafer verwendet wird, nahezu keine Schubspannungen τ aushält, entsteht nun gemäß Figur 4 ein Haarriss 5 im Bereich des Auflagepunktes AP.

Figur 5 zeigt eine vereinfachte perspektivische Ansicht dieses Vorgangs gemäß Figur 4, wobei gleiche Bezugszeichen gleiche oder entsprechende Elemente bezeichnen und auf eine wiederholte Beschreibung nachfolgend verzichtet wird.

Gemäß Figur 5 wird demzufolge am Auflagepunkt AP eine Schubspannung τ_{öz} erzeugt. Genauer gesagt greift demzufolge eine Kraft an der nach Ö infinitesimalen Fläche in z-Richtung an. Das Material des scheibenförmigen Gegenstandes und insbesondere monokristallines Silizium-Halbleitermaterial kann diesen Schubspannungen τ jedoch nicht widerstehen und verändert daher sprungartig seine Ortskoordinaten von der eine Seite des Haarrisses 5 zu der anderen Seite. Derartige Haarrisse 5 pflanzen sich sehr leicht insbesondere in ultradünnen Halbleiterwafern 1A fort, weshalb sie eine wesentliche Ursache für die außerordentlich hohe Bruchgefahr bei derartigen ultradünnen Halbleiterwafern darstellen.

Zur Vermeidung einer derartigen Zerbrechlichkeit von ultradünnen Halbleiterwafern wurden entweder speziell adaptierte Transportvorrichtungen und sogenannte Chucks in den Bearbeitungsmaschinen mit beispielsweise speziellen Transporthorden zur Verfügung gestellt, wobei ein Waferbruch nur reduziert, jedoch nicht ausgeschlossen werden kann. Insbesondere mit der Zunahme eines Durchmessers von Halbleiterwafern von 150 mm auf über 300 mm können derartige Probleme jedoch nicht vollständig beseitigt werden.

Gemäß einer alternativen Lösungsmöglichkeit werden Trägerwafer verwendet, wobei ein ultradünner Produktwafer auf einem normal dicken Trägerwafer mit hoch- oder mitteltemperaturfesten Verbindungsmaterialien verbunden wird. Nachteilig bei einer derartigen Trägertechnik sind jedoch die zusätzlichen Investitionen sowie hohen Herstellungskosten.

Ein weiterer Ansatz, die Zerbrechlichkeit insbesondere von ultradünnen Halbleiterwafern zu vermindern, ist beispielsweise das Nachbearbeiten der Kante bzw. des Umfangsrandes mit einem kombinierten Wasserstrahl-Laserschneidegerät. Der Waferbruch lässt sich jedoch nur um einen bestimmten Prozentsatz verringern.

Der Erfindung liegt daher die Aufgabe zu Grunde, ein Verfahren zur Herstellung eines bruchfesten scheibenförmigen Gegenstandes sowie eine zugehörige Halbleiterschaltungsanordnung zu schaffen, wobei die Zerbrechlichkeit insbesondere von ultradünnen scheibenförmigen Gegenständen wesentlich verringert ist.

Erfindungsgemäß wird diese Aufgabe hinsichtlich des Verfahrens durch die Maßnahmen des Patentanspruchs 1 und hinsichtlich der Halbleiterschaltungsanordnung durch die Merkmale des Patentanspruchs 17 gelöst.

Insbesondere durch das Ausbilden von zumindest einem Graben im Bereich des Sägerahmens, dem Auffüllen des Grabens mit einem schubspannungsfesten Material, dem Ausbilden einer Galvanisierungsmaske mit frei liegenden Bereichen an der Vorderseite des Trägersubstrats und dem Durchführen einer Galvanisierung zum Auffüllen der frei liegenden Bereiche der Galvanisierungsmaske können die für die Zerbrechlichkeit von ultradünnen Halbleiterwafern verantwortlichen Schubspannungen sehr effektiv aufgefangen werden, wodurch ein Waferbruch wesentlich verringert ist. Hierbei ermöglicht eine in den freiliegenden Bereichen der Galvanisierungsmaske ausgebildete galvanische Füllschicht erstmalig auch ein Dünnen des scheibenförmigen Gegenstands auf Enddicken unterhalb von 10 µm.

Vorzugsweise wird das Auffüllen der Gräben sowie das Ausbilden der Galvanisierungsmaske gleichzeitig durchgeführt, wobei beispielsweise ein fotosensitiver Lack als schubspannungsfestes Material ganzflächig aufgeschleudert sowie in die Gräben eingebracht und zur Ausbildung der Galvanisierungsmaske fotolithographisch strukturiert wird. Auf diese Weise kann das Verfüllen der Gräben mit schubspannungsfestem Material und das Ausbilden der Galvanisierungsmaske sehr kostengünstig realisiert werden. Als fotosensitiver Lack wird vorzugsweise Fotoimid verwendet.

Alternativ kann jedoch auch ein metallisches Material als schubspannungsfestes Material in den Gräben galvanisch aufgefüllt werden, wodurch sich die Resistenz gegenüber Schubspannungen weiter verbessert.

Zum Durchführen der Galvanisierung erfolgt vorzugsweise eine sehr gleichförmige Kontaktierung des Trägersubstrats von seiner Rückseite, wobei insbesondere ein Vakuumchuck mit einer Vielzahl von Kontaktspitzen und dazwischenliegenden Vakuumkanälen für die gleichförmige Kontaktierung verwendet werden kann. Auf diese Weise erhält man insbesondere bei Halbleiterwafern zum einen eine hinreichende Angriffskraft, mit der ein natürliches Oxid am Halbleiterwafer und/oder den Kontaktspitzen zerstört wird und eine für die Galvanisierung notwendige gleichförmige Kontaktierung ermöglicht ist. Insbesondere können dadurch sogenannte "seed layer"-freie Metallschichten ausgebildet werden, wobei die Galvanisierungsmaske gemeinsam mit der galvanischen Füllschicht eine besonders hohe Resistenz gegenüber Schubspannungen aufweist.

Ferner kann eine elektrisch leitende Hilfsstruktur zur Galvanisierung von isolierten freiliegenden Bereichen der Galvanisierungsmaske ausgebildet werden, die mit einer Isolierschicht bedeckt sind und somit nicht unmittelbar galvanisiert werden können. Derartige isolierte frei liegende Bereiche sind beispielsweise Gate-Anschlussbereiche.

Vorzugsweise wird hierbei eine Leiterbahnstruktur als Hilfsstruktur verwendet, die von einem Substratbereich im Sägerahmen zu den isolierten frei liegenden Bereichen führt und somit eine Galvanisierung auch auf isolierten Bereichen ermöglicht.

Hinsichtlich der Halbleiterschaltungsanordnung werden vorzugsweise zumindest ein Graben an einem Bausteinrand im Substrat ausgebildet und mit einem schubspannungsfesten Material aufgefüllt, sowie eine Galvanisierungsmaske an der Oberfläche des Halbleitersubstrats mit einer Vielzahl von frei liegenden Bereichen ausgebildet, wobei eine galvanische Füllschicht die Vielzahl von frei liegenden Bereichen der Galvanisierungsmaske im Wesentlichen gleichförmig auffüllt. Wiederum erhält man dadurch eine erhöhte Widerstandsfähigkeit gegenüber Schubspannungen wodurch man Halbleitersubstrate mit einer Dicke bis zu 5 µm ausbilden kann. Einerseits erhöhen sich dadurch die Möglichkeiten einer Rückseitenprozessierung, wobei andererseits vollkommen neuartige Halbleiterschaltungen entwickelt werden können.

Vorzugsweise weist die Halbleiterschaltungsanordnung eine Vielzahl von Leistungstransistoren auf, deren Gateschichten über einen Gate-Anschlussbereich angeschlossen werden können.

In den weiteren Unteransprüchen sind weitere vorteilhafte Ausgestaltungen der Erfindung gekennzeichnet.

Die Erfindung wird nachstehend anhand von Ausführungsbeispielen unter Bezugnahme auf die Zeichnung näher beschrieben.

Es zeigen:
- Figur 1: eine vereinfachte Seitenansicht eines herkömmlichen Halbleiterwafers bei der Ablage in einer Horde;
- Figur 2: eine vereinfachte Seitenansicht eines ultradünnen Halbleiterwafers bei der Ablage in einer Horde;
- Figuren 3A bis 3D: grafische Darstellungen zur Veranschaulichung einer Schnittkraft, einer Querkraft und einer Schubspannung für einen einseitig eingespannten Träger;
- Figur 4: eine vereinfachte Teil-Draufsicht eines herkömmlichen Halbleiterwafers mit Haarriss;
- Figur 5: eine vereinfachte perspektivische Teilansicht eines herkömmlichen Halbleiterwafers mit Haarriss;
- Figuren 6A bis 6C: vereinfachte Teil-Schnittansichten zur Veranschaulichung wesentlicher Verfahrensschritte bei der Herstellung eines bruchfesten Halbleiterwafers gemäß einem ersten Ausführungsbeispiel;
- Figuren 7A bis 7D: vereinfachte Teil-Schnittansichten sowie eine Teil-Draufsicht zur Veranschaulichung wesentlicher Verfahrensschritte beim Auffüllen der Gräben mit einem schubspannungsfesten Material gemäß einem zweiten Ausführungsbeispiel;
- Figur 8: eine vereinfachte Teil-Draufsicht eines bruchfesten Halbleiterwafers gemäß einem dritten Ausführungsbeispiel;
- Figur 9: eine vereinfachte Teil-Schnittansicht eines bruchfesten Halbleiterwafers entlang eines Schnitts A-A gemäß Figur 8; und
- Figur 10: eine vereinfachte Teil-Schnittansicht eines Zellenfeldes des bruchfesten Halbleiterwafers gemäß einem vierten Ausführungsbeispiel.

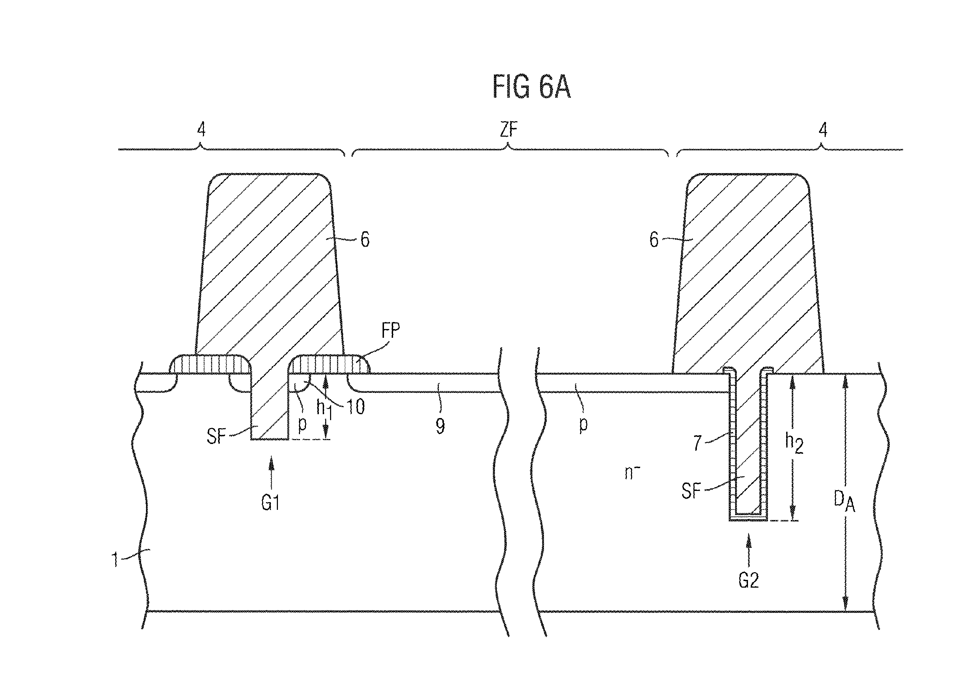

Figur 6A zeigt eine vereinfachte Teil-Schnittansicht eines bruchfesten Halbleiterwafers bzw. Trägersubstrats 1 vor einem Dünnen, wobei gleiche oder entsprechende Schichten wie in den Figuren 1 bis 5 bezeichnen und auf eine wiederholte Beschreibung nachfolgend verzichtet wird.

Gemäß Figur 6A besteht das elektrisch leitende Trägersubstrat 1 beispielsweise aus einem Halbleiterwafer und insbesondere aus einem Silizium-Halbleiterwafer von einem ersten Leitungstyp n⁻ mit einer herkömmlichen Anfangsdicke D_{A} von ca. 500 bis 1000 µm.

Zur Erhöhung einer Bruchfestigkeit wird gemäß Figur 6A zunächst im Bereich des Sägerahmens bzw. Ritz-Rahmens 4 zumindest ein Graben G1 mit einer geringen ersten Grabentiefe h1 von beispielsweise 5 bis 50 µm und/oder zumindest ein Graben G2 mit einer zweiten Grabentiefe h2 von beispielsweise 50 bis 200 µm an der Vorderseite des elektrisch leitenden Trägersubstrats bzw. Halbleiterwafers 1 ausgebildet.

Da der Sägerahmen 4 gemäß Figuren 4 und 5 im Wesentlichen eine gitterförmige Struktur aufweist und die einzelnen integrierten Schaltungen 3 voneinander beabstandet sind, besitzen auch die im Bereich des Sägerahmens 4 ausgebildeten Gräben G1 bzw. G2 im Wesentlichen eine gitterförmige Struktur. Die Ausbildung der im Wesentlichen matrixförmigen, d.h. in Zeilen und Spalten ausgebildeten Gräben G1 bzw. G2 kann beispielsweise mittels Plasmaätzen, nasschemischem Ätzen in einer Kalilauge, lichtinduziertem Ätzen, anodischem Siliziumätzen, Laserschneiden und/oder mechanischem Sägen durchgeführt werden.

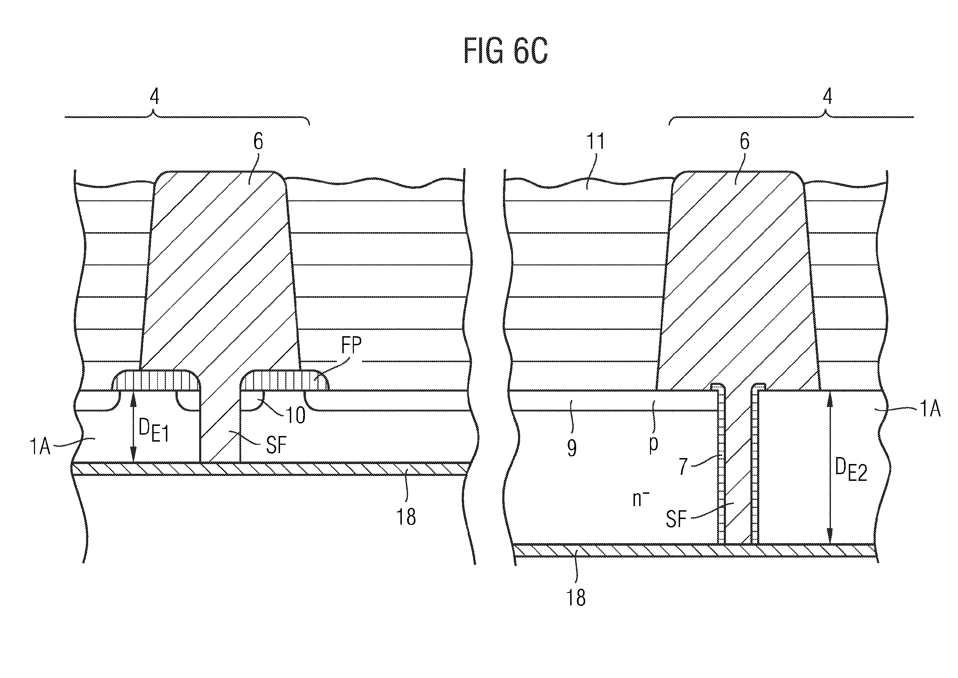

Vorzugsweise ist eine Grabentiefe h1 bzw. h2 der Gräben G1 bzw. G2 größer als eine in Figur 6C dargestellte Enddicke D_{E1} bzw. D_{E2} eines gedünnten bzw. ultradünnen Halbleiterwafers 1A. Bei der Realisierung von ultradünnen Halbleiterwafern 1A beträgt demzufolge die erste Grabentiefe h1 ca. 5 bis 50 µm, wobei insbesondere Niederspannungs-Bauelemente wie z.B. Niederspannungs-Leistungstransistoren realisiert werden können, oder die zweite Grabentiefe h2 ca. 50 bis 200 µm, wobei vorzugsweise Hochspannungs-Bauelemente wie z.B. Hochspannungs-Leistungstransistoren realisiert werden können.

Eine Grabenbreite wird hierbei in Abhängigkeit von einem verwendeten Füllmaterial derart dimensioniert, dass das später einzubringende Füllmaterial möglichst einfach in die Gräben G1 bzw. G2 eingebracht werden kann. Vorzugsweise besitzen die Gräben G1 bzw. G2 eine Grabenbreite von 5 bis 100 µm und können demzufolge problemlos innerhalb des Sägerahmens 4 positioniert werden.

Gemäß Figur 6A kann der Graben G2 beispielsweise eine passivierende Schicht 7 an seiner Grabenoberfläche aufweisen, wodurch insbesondere bei Hochspannungs-Bauelementen verbesserte Isolationseigenschaften realisiert werden. Andererseits können auch für Niedervolt-Bauelemente beispielsweise isolierende Oxide als Feldplattenstruktur FP an den Seiten der flachen Gräben G1 ausgebildet werden, die darüber hinaus in ihren oberen Kanten Kanalstoppgebiete 10 als beispielsweise p-Diffusionsgebiete aufweisen können. Ein eigentliches Zellfeld ZF weist hierbei beispielsweise eine p-Wanne 9 an der Oberfläche des Halbleitersubstrats 1 auf.

Nach dem Ausbilden der Gräben G1 bzw. G2 im Bereich der Sägerahmen 4 erfolgt gemäß dem dargestellten ersten Ausführungsbeispiel nunmehr ein Auffüllen der Gräben mit einem schubspannungsfesten Material SF. Vorzugsweise wird hierbei ein Duroplast im Bereich des Sägerahmens 4 aufgebracht und anschließend vernetzt bzw. gehärtet, wodurch man ein mitteltemperaturfestes Material zum Kompensieren der eingangs erwähnten Schubspannungen erhält.

Insbesondere wird gemäß Figur 6A als schubspannungsfestes Material SF vorzugsweise ein fotosensitiver Lack ganzflächig aufgeschleudert, wobei man zunächst eine ca. 10 bis 50 µm dicke Fotolackschicht erhält. Die Fotolackschicht wird hierbei nicht nur in die Gräben G1 und G2 eingebracht, sondern dient ferner der Ausbildung einer Galvanisierungsmaske 6. Genauer gesagt wird hierbei nach dem Aufschleudern des fotosensitiven Lacks (vorzugsweise Fotoimid) und gleichzeitigen Auffüllen der Gräben G1 bzw. G2 anschließend eine fotolithografische Strukturierung durchgeführt, wobei vorzugsweise in den Bereichen des Ritzrahmens 4 bzw. der Gräben G1 bzw. G2 eine Belichtung erfolgt und somit der Fotolack anschließend vom Zellenfeld ZF entfernt bzw. gestrippt werden kann. Da insbesondere Fotoimid in einer Vielzahl von Standardprozessen verwendet wird und bis ca. 400°C temperaturbeständig ist, ist es als schubspannungsfestes Material SF für Prozessschritte in einem nachfolgenden Mitteltemperaturbereich gut geeignet. Auf diese Weise können die Gräben G1 bzw. G2 gleichzeitig mit einem schubspannungsfesten Material SF aufgefüllt als auch die Galvanisierungsmaske 6 an der Vorderseite des Halbleiterwafers 1 ausgebildet werden, wodurch man eine sehr effektive Prozessierung erhält.

Während eine derartige Struktur für bis auf eine Dicke von 50 µm gedünnte Halbleiterwafer ausreichend ist, sind insbesondere für ultradünne Halbleiterwafer in einem Dickenbereich von 5 µm bis 50 µm die mechanischen Verbindungseigenschaften des schubspannungsfesten Materials SF nicht ausreichend, wobei insbesondere die strukturierte Fotolackschicht nicht akzeptable Dickenschwankungen aufweist.

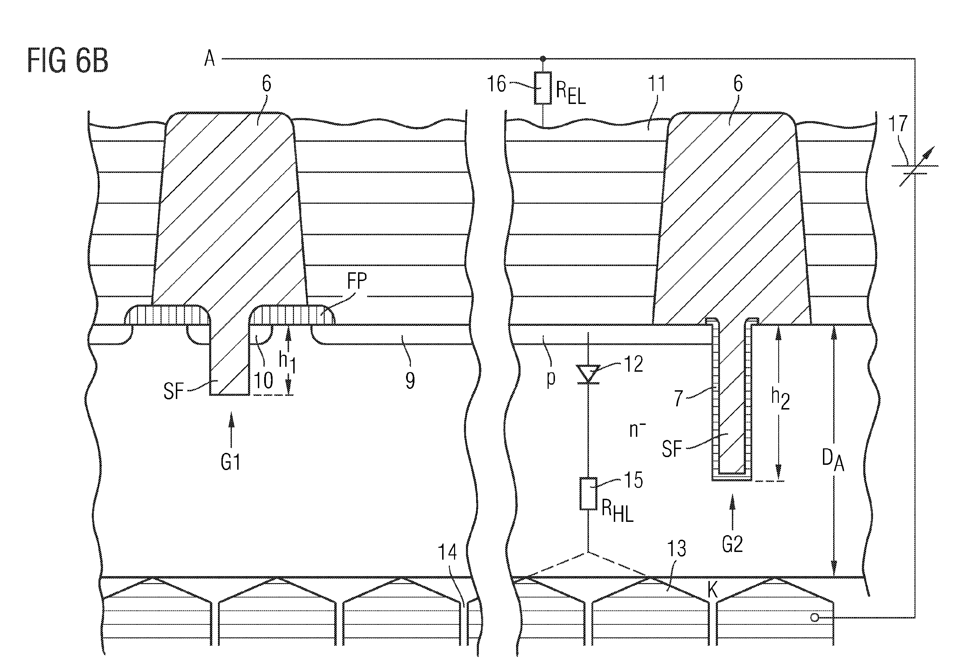

Gemäß Figur 6B wird demzufolge eine Galvanisierung zum Auffüllen der freiliegenden Bereiche der Galvanisierungsmaske 6 durchgeführt, wobei insbesondere eine gleichförmige Kontaktierung des Trägersubstrats bzw. Halbleiterwafers 1 von seiner Rückseite erfolgt. Vor diesem Galvanisierungsschritt kann optional ein weiteres Schleifen des Halbleiterwafers 1 zur Verringerung von Schwankungen der Anfangsdicke D_{A} durchgeführt werden, welche insbesondere für ultradünne Halbleiterwafer in einem Dickenbereich von 5 bis 50 µm notwendig ist.

Da das Verfahren insbesondere ohne Verwendung von sogenannten "Seed Layern" bzw. Keimschichten durchgeführt werden soll, benötigt man eine außerordentlich gleichförmige Kontaktierung des gesamten Trägersubstrats bzw. Halbleiterwafers 1, damit dieser eine Kathode K der bei der Galvanisierung verwendeten elektrochemischen Zelle darstellt. Die Bedeutung dieser gleichförmigen Kontaktierung auf der Rückseite des Halbleiterwafers 1 wird anhand eines nachfolgend dargestellten Beispiels einer Widerstandsberechnung erläutert:

Unter der Annahme eines ungünstigsten Falles weist ein Halbleitersubstrat einen spezifischen Widerstand von 60 Ohm x cm auf, also das Grundmaterial für 1200 Volt sperrende Halbleiterbauelemente. Da der Halbleiterwafer üblicherweise ca. 500 µm bzw. 0,5 mm dick ist, beträgt der Halbleiter-Serienwiderstand 15 bzw. R_{HL} also ca. 3 Ohm. Der Elektrolyt-Serienwiderstand 16 bzw. R_{EL} eines bei der Galvanisierung benötigten Elektrolyten mit einer typischen Leitfähigkeit von 100 mSiemens beträgt bei einem Elektrodenabstand von ca. einem Zentimeter von der Waferoberfläche 0,1 Ohm, also deutlich weniger als der Widerstand R_{HL} im Halbleiter. Der Spannungsabfall an der Doppelschicht, an der die elektrochemische Reaktion zur Abscheidung eines lötfähigen Metalls, vorzugsweise Kupfer oder Nickel stattfindet, liegt in der Größenordnung von 0,5 Volt. Diese Spannung muss also mit den Spannungsabfällen über das Halbleitersubstrat 1 und den Elektrolyten verglichen werden, um beurteilen zu können, ob die Chance auf einen gleichmäßigen Prozess gegeben ist. Eine typische Stromdichte bei der Galvanik ist ca. 1 - 10 mA/cm². Dies in das Ohmsche Gesetz eingesetzt, ergibt im Elektrolyten einen Spannungsabfall von 0,1 mV und im Halbleitersubstrat von 3 mV, also deutlich weniger als die elektrochemische Überspannung am Ort der Abscheidungsreaktion. Hieraus ergibt sich die Voraussetzung für das Gelingen des erfindungsgemäßen Galvanisierungsprozesses. Würde man demgegenüber den Halbleiterwafer nur irgendwo am Rand kontaktieren, so lässt sich leicht berechnen, dass mit Serienwiderständen von bis zu etlichen kΩ zu rechnen wäre, was jede Chance auf Gleichförmigkeit zunichte machen würde.

Gemäß Figur 6B geschieht diese geforderte, gleichförmige Kontaktierung des Halbleiterwafers 1 durch eine Vorrichtung, die aus einer unebenen, mit vielen Spitzen behafteten Kontaktplatte besteht, wobei ihre hinreichende Angriffskraft beispielsweise mittels eines Vakuum-Chucks mit geeigneter Dichtung am Waferrand erzielt wird. Die Angriffskraft muss hierbei derart hoch sein, dass ein natürliches Oxid an dem Trägersubstrat bzw. den Kontaktspitzen 13 zerstört wird und der direkte Kontakt zum Halbleitermaterial gewährleistet ist. Da dies in der ebenen Oberfläche nicht zu erreichen ist, wird erfindungsgemäß ein Vakuum-Chuck mit einer Vielzahl von Kontaktspitzen 13 und dazwischen liegenden Vakuumkanälen 14 für die gleichförmige Kontaktierung verwendet. Der Vakuumchuck stellt hierbei die Kathode K dar und ist über eine Spannungsversorgung 17 mit der Anode bzw. dem Elektrolyten elektrisch verbunden. Für einen guten ohmschen Kontakt ist insbesondere Aluminium als Kontaktmetall für die Spitzen 13 geeignet, wobei jedoch auch bei entsprechend starker n-Substratdotierung des Halbleitersubstrats 1 Silber-Kontaktspitzen 13 verwendet werden können. Auf diese Weise lassen sich eine oder eine Vielzahl von galvanischen Füllschichten 11 in den freiliegenden Bereichen der Galvanisierungsmaske 6 derart ausbilden, dass sie schließlich eine im Wesentlichen gleichförmige Oberfläche mit den Höckern der Galvanisierungsmaske 6 ausbilden.

Für n-Halbleitersubstrate 1 ist somit ein Galvanikprozess beschrieben, der für den im Halbleitersubstrat 1 ausgebildeten pn-Übergang 12 leitend ist. Auf diese Weise kann beispielsweise durch Abscheidung von Kupfer und/oder Nickel direkt auf einem Halbleitermaterial wie z.B. Silizium eine Schubspannungsfestigkeit wesentlich erhöht werden.

Zur Realisierung eines entsprechenden Unterdrucks über die Vakuumkanäle 14 ist am Waferrand eine (nicht eingezeichnete, aber notwendige) Dichtung vorgesehen.

Auf Grund dieser gleichförmigen Kontaktierung erhält man somit ein gleichmäßiges Auffüllen der frei liegenden Bereiche der Galvanisierungsmaske 6, weshalb üblicherweise notwendige Planarisier- oder Schleifprozesse an der Vorderseite entfallen können.

Gemäß Figur 6C wird abschließend ein Dünnen des scheibenförmigen Gegenstands bzw. Halbleitersubstrats 1 von seiner Rückseite bis zu einer Enddicke D_{E1} bzw. D_{E2} zur Realisierung eines gedünnten Trägersubstrats bzw. ultradünnen Halbleiterwafers 1A durchgeführt, wobei die jeweiligen Enddicken D_{E1} bzw. D_{E2} kleiner sind als die Grabentiefen h1 bzw. h2 der ausgebildeten Gräben G1 und G2. Vorzugsweise wird hierbei ein mechanisches Schleifen mit nachfolgendem Spin-Ätzen und abschließendem Polieren durchgeführt, da der nasschemische Prozess die geforderten Dickenschwankungen der Gleichförmigkeit nicht erreichen lässt. Abschließend erfolgt die Ausbildung einer Rückseitenmetallisierung 18, die beispielsweise einen Drainanschluss darstellt.

Auf diese Weise werden Enddicken von 5 µm bis 200 µm eingestellt, die insbesondere für Niedervolt- und Hochvolt-Bauelemente geeignet sind.

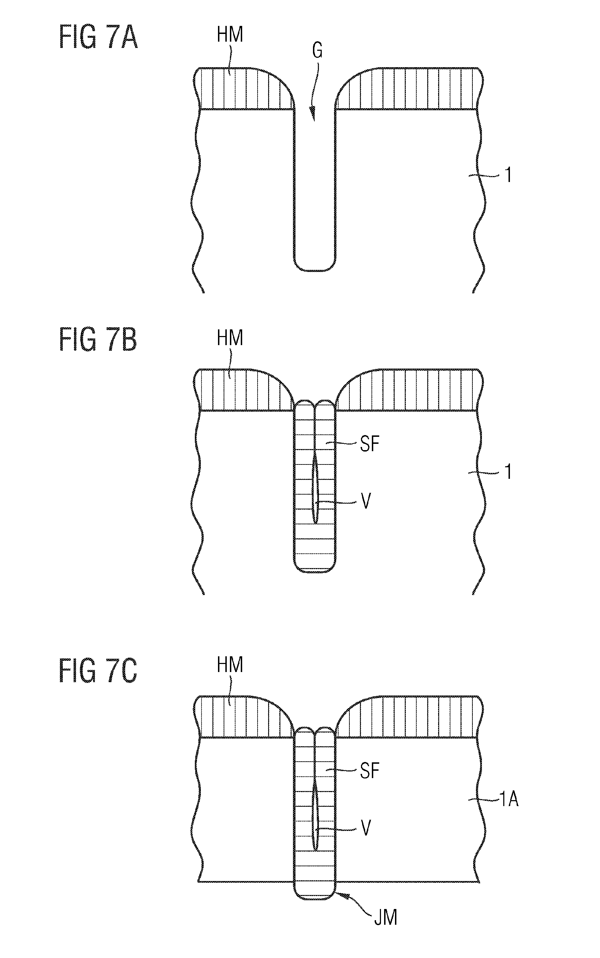

Figuren 7A bis 7C zeigen vereinfachte Teil-Schnittansichten zur Veranschaulichung eines alternativen Herstellungsschritts insbesondere für das Auffüllen der Gräben mit einem schubspannungsfesten Material, wobei gleiche Bezugszeichen gleiche oder entsprechende Schichten bzw. Elemente bezeichnen wie in den Figuren 1 bis 6 und auf eine wiederholte Beschreibung nachfolgend verzichtet wird.

Alternativ zum gleichzeitigen Ausbilden der Galvanisierungsmaske 6 und dem Auffüllen der Gräben mit einem schubspannungsfesten Material, wie es gemäß Figuren 6A bis 6C anhand eines Fotolacks beschrieben wurde, kann gemäß Figuren 7A bis 7C auch ein metallisches Material als schubspannungsfestes Material SF in den Gräben G galvanisch aufgefüllt werden.

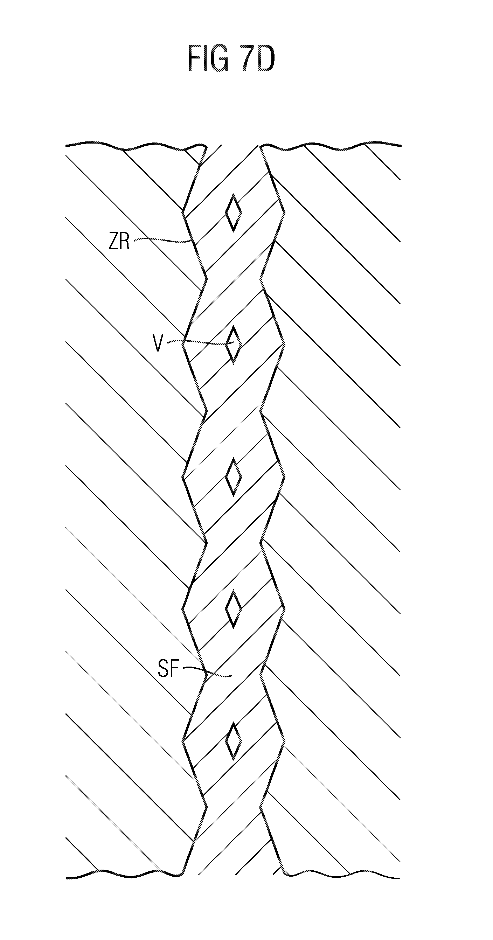

Gemäß Figur 7A können demzufolge mittels beispielsweise einer Oxid-Hartmaske HM nicht nur die Gräben G ausgebildet bzw. geätzt werden, sondern in einem Schritt gemäß Figur 7B unter Verwendung des vorstehend beschriebenen Galvanisierungsverfahrens und der Hartmaske HM als Schutzschicht auch mit einem metallischen Material als schubspannungsfestem Material SF aufgefüllt werden. Derartige galvanisch aufgebrachte Metalle SF weisen hierbei eine besondere Widerstandsfähigkeit gegenüber Schubspannungen auf, weshalb die Ausbreitung von Haarrissen in besonders dünnen Halbleiterwafern (d.h. kleiner 50 µm) besonders zuverlässig verhindert werden kann. Hohlräume bzw. sogenannte Voids V, die bei einer derartigen galvanischen Abscheidung in den Gräben bzw. im Füllmaterial SF ausgebildet werden, sind hierbei zu vermeiden, wozu ein Layout gemäß Figur 7D dienen kann.

Gemäß Figur 7D kann zur Vermeidung von Voids V in den Gräben G der Sägerahmen 4 das Layout beispielsweise in Form eines Zackenrandes ZR ausgeführt werden, was zur Folge hat, dass die Galvanisierung gezielt vor dem Zusammenwachsen des Metalls in den breiteren Gebieten des Zackenrandes ZR beendet wird, wobei dann der Anteil der Voids V klein ist gegen jenen Anteil der Grabenstärke, wo das Metall SF ordentlich zusammengewachsen ist. In diesem Zusammenhang sei angemerkt, dass die Voids V bei geraden Rändern nämlich unter Umständen von rein zufälligen, mikroskopisch kleinen Schwankungen in der Grabenbreite abhängig und daher in ihrem Ausmaß nicht kontrollierbar sind.

Nach einem Dünn-Schritt des Halbleiterwafers gemäß Figur 7C besitzt der gedünnte Halbleiterwafer 1A wiederum eine Enddicke, die kleiner ist als die Tiefe des Grabens G, wobei die an der Rückseite überstehenden Strukturen als Justiermarken JM für eine besonders einfache Vorder-Rückseiten-Justage verwendet werden können. Als schubspannungsfestes Material SF, welches galvanisch im Graben G ausgebildet wird, kann vorzugsweise Kupfer (Cu) verwendet werden.

Für Produkte, die auf ihrer Rückseite insbesondere auch strukturierte Hochtemperaturdiffusionen benötigen, ist aufgrund des besonders niedrigen, thermischen Ausdehnungskoeffizienten, Wolfram das Metall mit den günstigsten Eigenschaften, das in den Gräben G aufgalvanisiert wird.

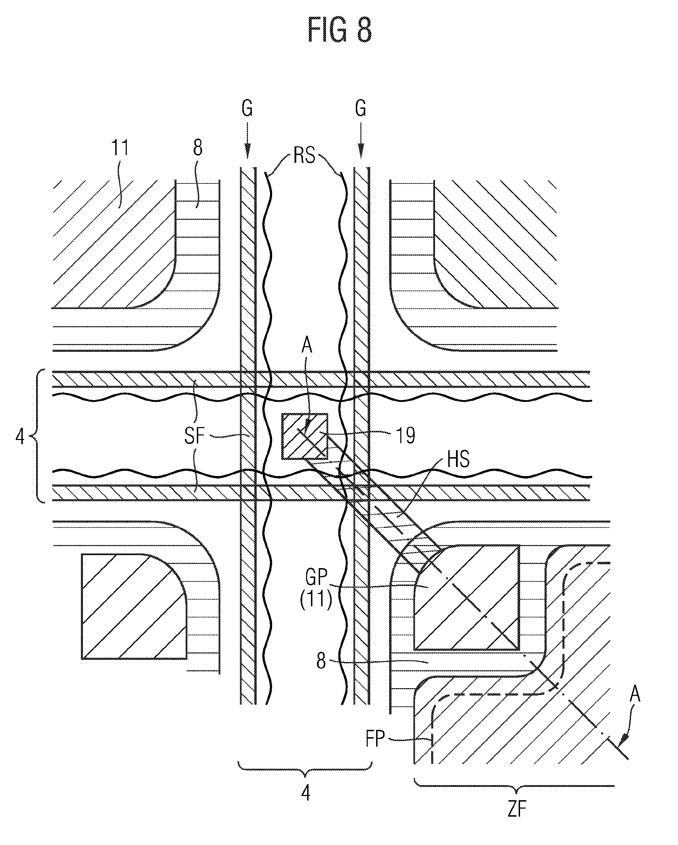

Figur 8 zeigt eine vereinfachte Teil-Draufsicht eines ultradünnen bruchfesten Halbleiterwafers gemäß einem dritten Ausführungsbeispiel, wobei gleiche Bezugszeichen wiederum gleiche oder entsprechende Elemente oder Schichten bezeichnen wie in den Figuren 1 bis 7 und auf eine wiederholte Beschreibung nachfolgend verzichtet wird.

Gemäß Figur 8 weist ein Sägerahmen 4 jeweils zwei voneinander beabstandete Gräben G auf, welche mit einem der vorstehend beschriebenen Verfahren ausgebildet bzw. aufgefüllt werden können. Die durch den Sägerahmen 4 voneinander getrennten Halbleiterbausteine weisen üblicherweise ein Zellenfeld ZF mit aktiven Bauelementen, aber auch sogenannten Anschlussflächen GP auf, welche üblicherweise auf Isolierschichten 8 ausgebildet sind und somit zumindest zunächst nicht unmittelbar galvanisiert werden können. Zur Realisierung einer Galvanisierung auch von derartigen isolierten freiliegenden Bereichen, wie sie beispielsweise die in Figur 8 dargestellten Gate-Anschlussbereiche GP darstellen, wird demzufolge eine Hilfsstruktur HF vorgeschlagen, die aus einem elektrisch leitenden Material besteht und von einem Substratbereich 19 im Sägerahmen 4 zu den isolierten freiliegenden Bereichen GP führt. Vorzugsweise können hierfür Leiterbahnstrukturen verwendet werden, die unmittelbar auf der Substratoberfläche oder der Oberfläche der Isolierschicht 8 ausgebildet und strukturiert sind.

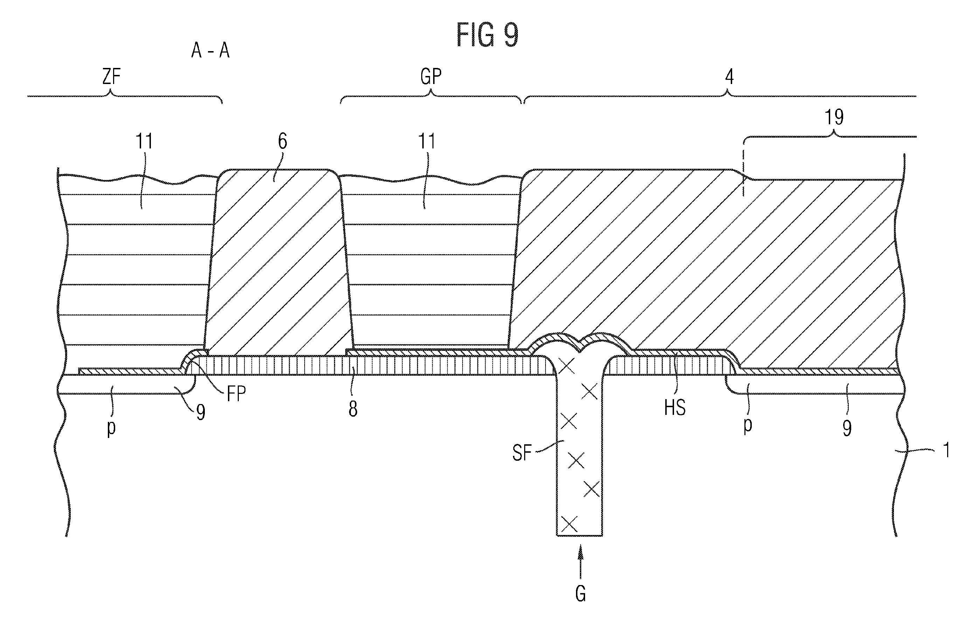

Figur 9 zeigt eine vereinfachte Teil-Schnittansicht entlang eines Schnitts A-A gemäß Figur 8, wobei gleiche Bezugszeichen gleiche oder entsprechende Schichten wie in den Figuren 1 bis 8 bezeichnen und auf eine wiederholte Beschreibung nachfolgend verzichtet wird.

Gemäß Figur 9 wird zum Auffüllen des freiliegenden, jedoch durch die Isolierschicht 8 isolierten Bereichs GP für die Gate-Anschlussbereiche eine Hilfsstruktur HF an der Oberfläche des Halbleiterwafers 1 und zumindest an der Oberfläche der Isolierschicht 8 im freiliegenden isolierten Bereich GP bis zu einem Substratbereich 19 im Sägerahmen 4 beispielsweise über einen Graben G ausgebildet und strukturiert, wodurch man eine Kontaktierung vom Substratbereich 19 bis zum isolierten freiliegenden Bereich GP erhält. Auf diese Weise kann auch der isolierte freiliegende Bereich galvanisch aufgefüllt werden, wodurch nicht nur Schubspannung verringerndes Material sondern auch beispielsweise ein sogenannter Gate-Anschlussbereich bzw. Gate-Pad GP mittels der vorstehend beschriebenen Galvanisierungsverfahren ausgebildet werden kann.

Da der Gate-Anschlussbereich GP mit dem Halbleitersubstrat über die Hilfsstruktur verbunden ist, muss es vor Benutzung der Halbleiterbausteine von diesem wieder getrennt werden, was im Zuge des Wafersägens bzw. Vereinzelns automatisch geschieht. Die Linien RS deuten hierbei die Ränder der Sägespur im Sägerahmen 4 an, wodurch die Gate-Anschlussbereiche GP vom elektrisch leitenden Trägersubstrat getrennt werden.

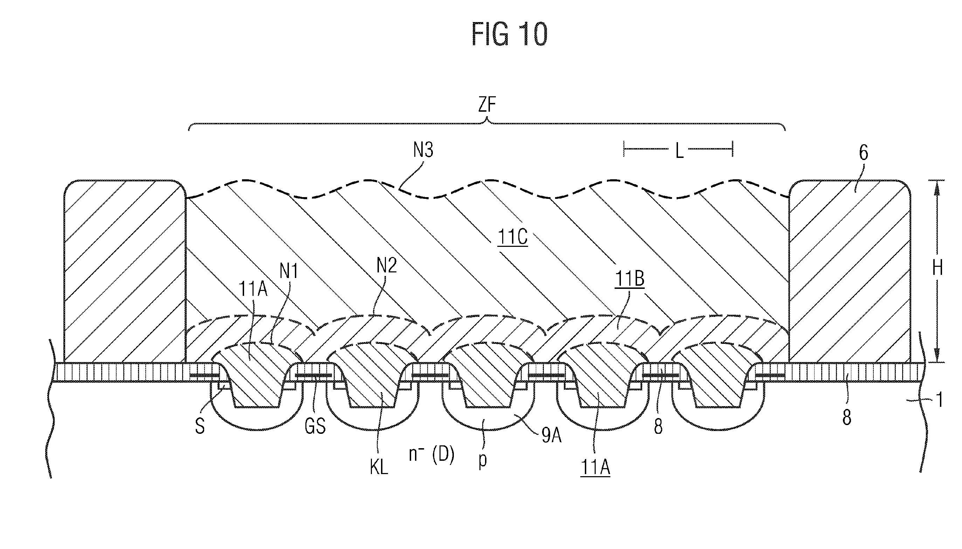

Figur 10 zeigt eine vereinfachte Teil-Schnittansicht eines Zellenfeldes ZF gemäß einem vierten Ausführungsbeispiel, wobei gleiche Bezugszeichen gleiche oder entsprechende Schichten bzw. Elemente bezeichnen wie in den Figuren 1 bis 9 und auf eine wiederholte Beschreibung nachfolgend verzichtet wird.

Im Gegensatz zu der in Figur 9 dargestellten p-Wanne 9, welche im Wesentlichen im Zellenfeld ZF ausgebildet ist, können gemäß Figur 10 auch komplexe Halbleiterbauelemente und insbesondere (in Abhängigkeit von einer jeweiligen Substratdicke) Niedervolt-Leistungstransistoren oder Hochvolt-Leistungstransistoren ausgebildet werden.

Gemäß Figur 10 werden demzufolge in einem n⁻-Halbleitersubstrat 1 lokale p-Wannen 9A als sogenannte p-Bodies ausgebildet, in die an der Oberfläche Sourcegebiete S eingebracht werden. An der Oberfläche des Halbleitersubstrats 1 befinden sich in üblicher Weise eine (nicht dargestellte) Gate-Isolationsschicht, eine Gateschicht GS sowie eine Isolationsschicht 8, welche zu Zell-Stapeln strukturiert sind. Zwischen jedem Zell-Stapel mit einem Ausmaß L sind ferner Kontaktlöcher KL in das Halbleitersubstrat 1 bzw. die p-Wannen 9A sowie durch die Sourcegebiete S hindurch ausgebildet, wodurch die vorstehend beschriebene Galvanisierung durchgeführt werden kann.

Demzufolge werden in einer ersten Phase des Galvanisierungsverfahrens die galvanische Füllschicht 11A bis zu einer Linie bzw. einem Niveau N1 aufgewachsen, wobei man zunächst voneinander getrennte Galvanisierungsstöpsel bzw. -pilze erhält. In einer nachfolgenden Phase des Galvanisierungsprozesses wachsen diese Pilze 11A zusammen, wodurch man eine galvanische Füllschicht 11B beispielsweise bei einer Linie bzw. einem Niveau N2 erhält. Schließlich werden die freiliegenden Bereiche der Galvanisierungsmaske 6 bis zu einer Linie bzw. einem Niveau N3 mit galvanischem Füllmaterial 11C aufgefüllt, wodurch eine im Wesentlichen gleichförmige Oberfläche entsteht. Das erfindungsgemäße Galvanisierungsverfahren ist insbesondere dann anwendbar, wenn das Zellraster L der Leistungstransistoren wesentlich kleiner ist als eine Höhe H der Galvanisierungsmaske bzw. -höcker 6.

Obwohl im vorliegenden Verfahren vorzugsweise das gleiche galvanische Material als Füllschicht 11 verwendet wird, können alternativ auch verschiedene Metalle als galvanische Füllschichten 11A bis 11C in den frei liegenden Bereichen der Galvanisierungsmaske 6 abgeschieden werden, wodurch beispielsweise Barriereschichten oder sonstige elektrische Eigenschaften (Lötbarkeit) verbessert werden können.

Auf diese Weise können erstmals auch nur wenige µm dünne Niedervolt-Leistungstransistoren mit hoher Ausbeute und damit kostengünstig hergestellt werden.

Gemäß der vorliegenden Erfindung werden durch Ausbilden von Gräben und Auffüllen dieser Gräben mit schubspannungsfestem Material scheibenförmige Gegenstände und insbesondere Halbleiterwafer unzerbrechlich gemacht. Damit diese Gegenstände bzw. Halbleiterwafer aber nach einem Dünnen weiterhin handhabbar bleiben, werden die scheibenförmigen Gegenstände bzw. Halbleiterwafer durch Galvanisierungsmasken und dazwischen liegende galvanische Füllschichten weiter stabilisiert, wodurch man hochbruchfeste Halbleiterwafer und zugehörige Halbleiterschaltungsanordnungen erhält.

Die Erfindung wurde vorstehend anhand eines Silizium-Halbleiterwafers beschrieben. Sie ist jedoch nicht darauf beschränkt und umfasst in gleicher Weise auch andere Halbleitermaterialien. In gleicher Weise können als schubspannungsfeste Materialien auch andere Materialien als Fotoimid oder Kupfer verwendet werden, die ähnliche Eigenschaften zur Verringerung bzw. Verhinderung der eingangs genannten Schubspannungen aufweisen.

## Patentansprüche

1. Verfahren zur Herstellung eines bruchfesten scheibenförmigen Gegenstands mit den Schritten:
a) Vorbereiten eines elektrisch leitenden Trägersubstrats (1) mit einer Anfangsdicke (D_{A}) und einem Sägerahmen (4);
b) Ausbilden von zumindest einem Graben (G1, G2) im Wesentlichen im Bereich des Sägerahmens (4) an einer Vorderseite des Trägersubstrats (1);
c) Auffüllen des zumindest einen Grabens (G1, G2) mit einem schubspannungsfesten Material (SF);
d) Ausbilden einer Galvanisierungsmaske (6) mit freiliegenden Bereichen an der Vorderseite des Trägersubstrats (1);
e) Durchführen einer Galvanisierung des Trägersubstrates (1) zum Auffüllen der freiliegenden Bereiche der Galvanisierungsmaske (6); und
f) Dünnen des Trägersubstrats (1) von seiner Rückseite bis zu einer Enddicke (D_{E1}, D_{E2}) zur Realisierung eines gedünnten Trägersubstrats (1A), wobei
in Schritt b) zumindest ein Graben (G1, G2) mit einer Grabentiefe (h1, h2) ausgebildet wird, die größer ist als die Enddicke (D_{E1}, D_{E2}) des gedünnten Trägersubstrats (1A).

2. Verfahren nach Patentanspruch 1,
**dadurch gekennzeichnet, dass** in Schritt a) ein Halbleiterwafer von einem ersten Leitungstyp (n⁻) verwendet wird.

3. Verfahren nach Patentanspruch 1 oder 2,
**dadurch gekennzeichnet, dass** in Schritt b) ein Laserschneiden, Plasmaätzen, nasschemisches Ätzen, lichtinduziertes Ätzen, anodisches Ätzen und/oder Sägen durchgeführt wird.

4. Verfahren nach einem der Patentansprüche 1 bis 3,
**dadurch gekennzeichnet, dass**
die Schritte c) und d) gleichzeitig durchgeführt werden.

5. Verfahren nach Patentanspruch 4,
**dadurch gekennzeichnet, dass** ein photosensitiver Lack als schubspannungsfestes Material (SF) ganzflächig aufgeschleudert sowie in den zumindest einen Graben (G1, G2) eingebracht, und zur Ausbildung der Galvanisierungsmaske (6) fotolithographisch strukturiert wird.

6. Verfahren nach Patentanspruch 5,
**dadurch gekennzeichnet, dass** der photosensitive Lack Fotoimid darstellt.

7. Verfahren nach einem der Patentansprüche 1 bis 3,
**dadurch gekennzeichnet, dass**
in Schritt c) ein metallisches Material und insbesondere Wolfram als schubspannungsfestes Material (SF) im zumindest einen Graben (G) galvanisch aufgefüllt wird.

8. Verfahren nach einem der Patentansprüche 1 bis 7,
**dadurch gekennzeichnet, dass** vor Schritt e) ein Schleifen zur Verringerung von Schwankungen der Anfangsdicke (D_{A}) durchgeführt wird.

9. Verfahren nach einem der Patentansprüche 1 bis 8,
**dadurch gekennzeichnet, dass** in Schritt e) eine Vielzahl von galvanischen Metallschichten ausgebildet werden.

10. Verfahren nach einem der Patentansprüche 1 bis 9,
**dadurch gekennzeichnet, dass** in Schritt e) eine gleichförmige Kontaktierung des Trägersubstrats (1) von seiner Rückseite erfolgt.

11. Verfahren nach Patentanspruch 10,
**dadurch gekennzeichnet, dass** in Schritt e) ein Vakuumchuck mit einer Vielzahl von Kontaktspitzen (13) und dazwischenliegenden Vakuumkanälen (14) für die gleichförmige Kontaktierung verwendet wird.

12. Verfahren nach einem der Patentansprüche 1 bis 11,
**dadurch gekennzeichnet, dass** in Schritt f) ein mechanisches Schleifen mit nachfolgendem Spin-Ätzen und abschließendem Polieren durchgeführt wird.

13. Verfahren nach einem der Patentansprüche 1 bis 12,
**dadurch gekennzeichnet, dass** in Schritt f) bis zu einer Enddicke (D_{E1}, D_{E2}) von 5 µm bis 200 µm gedünnt wird.

14. Verfahren nach einem der Patentansprüche 1 bis 13,
**dadurch gekennzeichnet, dass** vor Schritt d) eine elektrisch leitende Hilfsstruktur (HS) zur Galvanisierung von isolierten freiliegenden Bereichen (GP) der Galvanisierungsmaske (6) ausgebildet wird, die mit einer Isolierschicht (8) bedeckt sind.

15. Verfahren nach Patentanspruch 14,
**dadurch gekennzeichnet, dass** die elektrisch leitende Hilfsstruktur (HS) eine von einem Substratbereich (19) im Sägerahmen (4) zu den isolierten freiliegenden Bereichen (GP) führende Leiterbahnstruktur darstellt.

16. Verfahren nach Patentanspruch 14 oder 15,
**dadurch gekennzeichnet, dass** die isolierten freiliegenden Bereiche Gate-Anschlussbereiche (GP) darstellen.

17. Halbleiterschaltungsanordnung mit
einem gedünnten Halbleitersubstrat (1A); und
zumindest einem Halbleiterbauelement (9; S, GS, D), welches im Halbleitersubstrat (1A) ausgebildet ist;
**gekennzeichnet durch**
zumindest einen Graben (G1, G2; G), der an einem Bausteinrand im Substrat (1A) ausgebildet und mit einem schubspannungsfesten Material (SF) aufgefüllt ist;
eine Galvanisierungsmaske (6), die an der Oberfläche des Halbleitersubstrats (1A) mit einer Vielzahl von freiliegenden Bereichen ausgebildet ist; und
einer galvanischen Füllschicht (11), welche die Vielzahl von freiliegenden Bereichen der Galvanisierungsmaske (6) im Wesentlichen gleichförmig auffüllt.

18. Halbleiterschaltungsanordnung nach Patentanspruch 17,
**dadurch gekennzeichnet, dass** die Galvanisierungsmaske (6) unmittelbar über dem zumindest einen Graben (G1, G2; G) ausgebildet ist und das gleiche Material aufweist wie das schubspannungsfeste Material (SF) des zumindest einen Grabens (G1, G2; G).

19. Halbleiterschaltungsanordnung nach Patentanspruch 18,
**dadurch gekennzeichnet, dass** das schubspannungsfeste Material (SF) des zumindest einen Grabens (G1, G2; G) und das Material der Galvanisierungsmaske (6) einen photosensitiven Lack und insbesondere Photoimid aufweist.

20. Halbleiterschaltungsanordnung nach Patentanspruch 17,
**dadurch gekennzeichnet, dass** das schubspannungsfeste Material (SF) des zumindest einen Grabens (G1, G2; G) eine galvanische Füllschicht und insbesondere Wolfram aufweist.

21. Halbleiterschaltungsanordnung nach einem der Patentansprüche 17 bis 20, **gekennzeichnet durch** eine elektrisch leitende Hilfsstruktur (HS), die an der Oberfläche des Halbleitersubstrats (1A) ausgebildet ist und von einem Bausteinrand zu isolierten freiliegenden Bereichen (GP) der Galvanisierungsmaske (6) führt, die mit einer Isolierschicht (8) bedeckt sind.

22. Halbleiterschaltungsanordnung nach einem der Patentansprüche 17 bis 21, **dadurch gekennzeichnet, dass** das zumindest eine Halbleiterbauelement (9; S, GS, D) einen vertikalen Leistungstransistor darstellt.

23. Halbleiterschaltungsanordnung nach Patentanspruch 22, **dadurch gekennzeichnet, dass** die isolierten freiliegenden Bereiche (GP) Gate-Anschlussbereiche für eine Gateschicht (GS) des Leistungstransistors darstellen.

24. Halbleiterschaltungsanordnung nach einem der Patentansprüche 17 bis 23, **dadurch gekennzeichnet, dass** der zumindest eine Graben (G) einen Zackenrand (ZR) aufweist.
